# EUROPÄISCHE PATENTSCHRIFT

(11) **EP 4 102 721 B1**
(45) Veröffentlichungstag und Bekanntmachung des Hinweises auf die Patenterteilung: **18.06.2025**
(21) Anmeldenummer: 21196673.4
(22) Anmeldetag: 14.09.2021
(51) Int. Cl.: H03K 17/687, H05B 39/08

(54) **ELEKTRONISCHER SCHALTER**
ELECTRONIC SWITCH
COMMUTATEUR ÉLECTRONIQUE

(30) Priorität: 11.06.2021 EP 21178982
(43) Veröffentlichungstag der Anmeldung: 14.12.2022
(73) Patentinhaber: GIRA Giersiepen GmbH & Co. KG, 42477 Radevormwald (DE)
(72) Erfinder: SEIFERT, Roland, 59071 Hamm (DE); DORNSEIFF, André, 51688 Wipperfürth (DE); MOLITOR, Rolf, 42859 Remscheid (DE)
(74) Vertreter: Dr. Solf & Zapf Patent- und Rechtsanwalts PartG mbB

(56) Entgegenhaltungen:
- EP-A1- 3 322 080
- EP-A1- 3 471 246
- US-A1- 2003 178 892

## Beschreibung

Die Erfindung betrifft einen elektronischen Schalter der Elektroinstallationstechnik, aufweisend einen ersten elektrischen Anschluss zum Anschließen eines L-Phasenleiters einer Wechselspannung eines Spannungsnetzes, einen zweiten elektrischen Anschluss zum Anschließen einer elektrischen Last, eine elektronische Schalteinrichtung zumindest zum Schalten der Last zwischen einem eingeschalteten Zustand und einem ausgeschalteten Zustand, eine elektronische Steuerung zum Ansteuern der Schalteinrichtung und Mittel für eine interne Eigenversorgungsspannung für die Steuerung unter Verwendung eines durch die Last fließenden Laststroms.

Derartige elektronische Schalter sollen insbesondere als Austauschgeräte für herkömmliche elektromechanische Schalter in der Elektroinstallationstechnik für Gebäude dienen. Letztere arbeiten des Öfteren in Zweidrahttechnik, das heißt, sie liegen zum Schalten zwischen dem L-Phasenleiter / Außenleiter des Wechselspannungsnetzes, in Europa zum Beispiel 230 V mit 50 Hz, und einem Schaltleiter zur Last. In einer herkömmlichen Gebäudeinstallation sind daher in den Schalterdosen an der Montagestelle häufig auch jeweils nur diese zwei Leitungen und kein N-Neutralleiter des Wechselspannungsnetzes vorhanden. Bei einem elektromechanischen Schalter ist bei einer derartigen Zweidrahttechnik im AUSZustand der Strom über die Last und damit auch über den Schalter gleich Null. Im EIN-Zustand ist demgegenüber die am Schalter abfallende Spannung gleich Null. Beide Zustände bieten somit schlechte Voraussetzungen für eine notwendige Eigenversorgungsspannung eines elektronischen Schalters. Insofern muss der elektronische Schalter abhängig von dem Laststrom der zu schaltenden Last mit einer Betriebsgleichspannung für die Schaltelektronik des Schalters versorgt werden.

Im Sinne der Erfindung bedeutet "eingeschalteter Zustand" der Last, dass zumindest so viel Spannung an der Last abfällt, dass ein Mensch die Last als eingeschaltet wahrnimmt (d.h. nicht notwendigerweise die gesamte Spannung an der Last abfällt). Entsprechend bedeutet "ausgeschalteter Zustand" der Last im Sinne der Erfindung, dass maximal so viel Strom durch die Last fließt, dass ein Mensch die Last noch als ausgeschaltet wahrnimmt (d.h. nicht notwendigerweise kein Strom durch die Last fließt).

Bekannt sind elektronische Schalter für Zweidrahttechnik, die sich selbst aus der angeschlossenen Last mit Strom nach dem Prinzip eines elektronischen Dimmers mittels Phasen-Schnitt versorgen. Im ausgeschalteten Zustand des Schalters fällt dabei ein wesentlicher Teil der Eingangswechselspannung am Schalter ab. Als Voraussetzung muss die angeschlossene Last dabei auch im ausgeschalteten Zustand noch einen niedrigen Stromfluss zulassen (ohne dabei für den Menschen wahrnehmbar in den eingeschalteten Zustand zu wechseln), das heißt, die Last darf im ausgeschalteten Zustand nicht ideal hochohmig sein. Das ist in der Regel bei den meisten herkömmlichen Lasten der Elektroinstallationstechnik in einem Gebäude auch der Fall, allerdings fällt je nach Last-Art und -Größe die Höhe des auch im ausgeschalteten Zustand zugelassenen (um nicht wahrnehmbar zu sein) Stroms sehr unterschiedlich aus.

Während größere Glühlampen (ohmsche Last) im ausgeschalteten Zustand mehrere Milliampere an Strom vertragen können, ohne dass es zum Beispiel zu unerwünschten, vom Menschen wahrnehmbaren Leuchterscheinungen kommt, kann es insbesondere bei neuen LED-Lampen (kapazitive Last) mit niedrigen Leistungswerten (< 10 W), die im ausgeschalteten Zustand wenige 100 Mikroampere zulassen, zu negativen Beleuchtungssituationen kommen, wie zum Beispiel Flackern und/oder Glimmen. Ist der Schalter ausgeschaltet, d.h. möglichst hochohmig, fällt möglichst die gesamte Spannung an ihm ab. Der Schalter benutzt die an ihm abfallende Spannung zur Eigenversorgung, dabei darf die Stromaufnahme aber den eventuell kleinen zulässigen Stromfluss durch die Last nicht überschreiten.

Ist der Schalter eingeschaltet, d.h. möglichst niederohmig, fällt möglichst keine Spannung an ihm ab, um die volle Leistung für die Last zur Verfügung zu stellen. Um nun trotzdem eine weitere Eigenversorgung sicherzustellen, wird der Schalter zyklisch kurzzeitig abgeschaltet, es fällt wieder (kurzzeitig) Spannung an ihm ab und durch die Last kann wieder ein Strom aufgenommen werden. Das Zeitintervall der Abschaltung ist dabei derart gewählt, dass die Abschaltung der Last für das menschliche Auge nicht wahrnehmbar ist und die Last insofern im eingeschalteten Zustand verbleibt.

Das zyklische Abschalten geschieht bei bekannten elektronischen Schaltern in der Regel in der Art eines Phasen-An- oder Abschnitts in jeder Halbwelle der Netzspannung (Dimmer-Prinzip). Dieses Prinzip funktioniert sehr gut bei rein ohmschen Lasten (ideale Sinusform des Laststroms), jedoch ergeben sich bei induktiver oder kapazitiver Last Nachteile, die zu Störungen und im Extremfall zur Zerstörung des elektronischen Schalters führen können.

Das Abschalten (bzw. kurzzeitige Abschalten wie beim Dimmen) einer induktiven Last, wie zum Beispiel eine Niedervolt-Halogen-Beleuchtung mit Transformator, erzeugt eventuell sehr hohe Überspannungen, wenn das jeweilige Abschalten nicht genau im Nulldurchgang des Stroms erfolgt. Insofern sollte bei einer induktiven Last nach dem Phasen-Anschnitts-Prinzip gearbeitet werden. Störungen auf dem Hausspannungsnetz machen es schwierig, den Nulldurchgang zu ermitteln.

Das Einschalten (bzw. kurzzeitige Einschalten wie beim Dimmen) einer kapazitiven Last, wie zum Beispiel LED-Beleuchtungen oder elektronische Trafos, erzeugt wegen der impulsförmigen Stromaufnahme im Scheitelpunkt der Netzspannung eventuell sehr hohe Stromspitzen, wenn das jeweilige Einschalten nicht genau im Nulldurchgang der Spannung erfolgt. Insofern sollte bei kapazitiven Lasten nach dem Phasen-Abschnitts-Prinzip gearbeitet werden. Allerdings erschwert der schnelle, impulsförmige Stromverlauf einer kapazitiven Last die Ermittlung des richtigen Zeitpunktes für das Einschalten der Last.

Das Ein- und Abschalten (bzw. kurzeitige Ein- und Abschalten wie beim Dimmen) von Misch-Lasten mit induktiven und kapazitiven Anteilen ist dabei besonders problematisch, da sich die Anforderungen an den Schalter bzw. Dimmer widersprechen. Bei bekannten elektronischen Schaltern kann manuell ein Modus für ohmsche, induktive oder kapazitive Lasten eingestellt werden, so dass zwischen Phasen-Anschnitts-Prinzip oder Phasen-Abschnitts-Prinzip manuell umgeschaltet werden kann.

Zudem besteht ein weiteres Problem, dass das kurzzeitige Abschalten in jeder Netzphase die Helligkeit einer angeschlossenen Lampen-Last sichtbar und dauerhaft verringert. Und diese Verdunkelung ist umso stärker, je länger die Last während jeder Netzphase abgeschaltet wird. Bei großen Lasten reicht in der Regel ein sehr kurzer Moment des Abschaltens aus, um die Steuerung des elektronischen Schalters selbst mit Strom zu versorgen. Dementsprechend gering fällt die Verdunkelung aus. Bei sehr kleiner Last, die heute in Form stromsparender LED-Beleuchtung sehr häufig vorkommt, muss aber eventuell für einen längeren Zeitraum je Netzphase abgeschaltet **bzw.** "gedimmt" werden. Die dadurch eventuelle starke Einschränkung der Helligkeit einer Lampen-Last ist unerwünscht. Bei extrem kleinen Lasten, z. B. LED-Lampen kleiner 10 W, reicht selbst ein Abschalten über die gesamte Netzphase oft nicht aus, den Schalter mit genügend Strom zu versorgen, da die kleine Last diesen Strom im "ausgeschalteten" Zustand gar nicht liefern kann.

Für bekannte elektronische Schalter für Zweidrahttechnik mit Dimmerfunktion, deren Eigenversorgung sich beim 2-Leiter-Anschluss ausschließlich aus dem Phasen-An- oder -Abschnitt speist, ergibt sich das Problem, dass die Last nicht für 100% der Zeit eingeschaltet werden kann, da die Dimmer-Elektronik dauerhaft mit einem gewissen Strom versorgt werden muss. Dadurch kann ein angeschlossenes Leuchtmittel nicht mit voller Helligkeit betrieben werden. Vielmehr muss in jeder Netz-Halbwelle für eine bestimmte Mindest-Zeit die Last abgeschaltet, sprich weiter gedimmt werden, damit Spannung zur Versorgung der eigenen Elektronik zur Verfügung steht. Entsprechend kann mit einem solchen bekannten Dimmer niemals die theoretisch mögliche maximale Helligkeit eines z.B. angeschlossenen Leuchtmittels erreicht werden.

Zur Eigenversorgung im ausgeschalteten Zustand wird insbesondere ein so genannter Offline-Schaltregler genutzt, der die relativ hohe Netzspannung in eine wesentlich niedrigere Spannung zur Eigenversorgung umsetzen kann, um nur wenig Strom zur Eigenversorgung aus dem Netz aufzunehmen. Diese Schaltregler benötigen zum bestimmungsgerechten Betrieb jedoch eine relativ hohe Mindest-Eingangsspannung, z.B. im Bereich von 40 bis 70 Volt. Dementsprechend kann der zur Eigenversorgung notwendige Phasen-An- oder -Abschnitt nicht bei möglichst geringer Netzspannung, z.B. nahe des Nulldurchgangs, vorgenommen und damit die Last möglichst nur gering beeinflusst werden, sondern es muss bei entsprechend höherer Spannung gedimmt werden. Bei gewünschter voller Leistung eines z.B. angeschlossenen Leuchtmittels ergibt sich dadurch bereits eine deutliche Reduzierung der Helligkeit.

Aus der EP 1 121 001 B1 ist ein elektronischer Schalter zum Schalten von Lasten mit niedriger oder hoher Impedanz, wie Glühlampen oder Leuchtstofflampen, bekannt. Dieser weist eine zum Ein- oder Ausschalten der Last ansteuerbare Schalteinrichtung mit mindestens einem in Reihe zu der Last liegenden Schaltelement und eine Spannungsversorgung zur internen Schalter-Eigenversorgung aus dem Wechselspannungsnetz mittels eines über die Last nachladbaren Puffer-Kondensators auf. Eine Steuerschaltung steuert die Schalteinrichtung an, wobei ein Nachladeinitiator der Steuerschaltung zur Eigenversorgung im eingeschalteten Zustand der Last in an den inneren Energiebedarf angepassten Zeitabständen jeweils einen Nachladevorgang des Puffer-Kondensators auslöst, wobei jeweils kurzzeitig die Schalteinrichtung zum Abschalten angesteuert und eine Betriebsgleichspannung über einen alternativen Strompfad gewonnen wird. Zudem weist die Steuerschaltung für die Eigenversorgung im ausgeschalteten Zustand der Last eine zusätzliche hochohmige Stromquelle aus drei Transistoren und fünf Widerständen auf. Diese Stromquelle verursacht in bestimmten Fällen bei besonders kleinen Lasten (z. B. kleiner 3 W LED-Lampen) einen zu hohen Ruhestrom, so dass diese im ausgeschalteten Zustand trotzdem eingeschaltet werden. Dies ist insbesondere dann problematisch, wenn die Schalter-Elektronik eigene Signal-LEDs oder einen Funk-Empfänger mitversorgen muss. Dadurch kann der Strombedarf in den Milliampere-Bereich steigen, wodurch der Laststrom auch im ausgeschalteten Zustand einer kleinen Last so hoch wird, dass die Last als eingeschaltet erscheint oder zumindest in einem unerwünschten undefinierten Zustand ist.

Nachteilig ist, dass die Betriebsgleichspannung für die Steuerung direkt über den Puffer-Kondensator gespeist wird. Dadurch ist der zulässige Spannungsbereich (in der Regel zwischen 2 V und 5 V) am Puffer-Kondensator relativ eng und direkt abhängig von der Steuerung, wodurch die Nachlademöglichkeiten eingeschränkt werden. Gleichzeitig muss der Puffer-Kondensator aber auch für den maximalen Laststrom ausgelegt werden, da ein Nachladevorgang unter Umständen auch im Scheitelwert des Laststroms auftreten kann, was wiederum bei besonders hohen Lasten, zum Beispiel > 300 W Glühlampen, berücksichtigt werden muss.

Zudem wird zur Berechnung der Zeitabstände für das Nachladen die Betriebsgleichspannung am Puffer-Kondensator durch einen Mikroprozessor überwacht und geregelt. Bei sehr kleinen Lasten mit zeitlich ungünstiger Stromaufnahme kann es für den Mikroprozessor sehr schwer werden, den richtigen Moment für das Nachladen bzw. das Abschalten des Nachladens des Puffer-Kondensators zu ermitteln. Bei sehr großen Lasten geschieht das Nachladen des Kondensators extrem schnell, und der Mikroprozessor, evtl. gerade auch noch mit anderen Funktionen beschäftigt, kann den richtigen Zeitpunkt für ein Beenden des Nachladens verpassen, wodurch der Kondensator beschädigt werden kann. Weitere Dokumente aus dem Stand der Technik, die sich mit diesem Problem befassen, sind EP3 322 080 A1 und EP3 471 246 A1.

Der Erfindung liegt die Aufgabe zugrunde, einen elektronischen Schalter für die Zweidrahtanschlusstechnik zur Verfügung zu stellen, der sowohl bei besonders hohen Lasten als auch besonders niedrigen Lasten wie auch bei ohmschen, induktiven und kapazitiven Lasten eine zuverlässige Schaltung ermöglicht und gleichzeitig möglichst einfach, kompakt, energiesparend und schonend für den elektronischen Schalter und für die Last aufgebaut ist.

Die Aufgabe wird erfindungsgemäß durch die Merkmale des Anspruchs 1 gelöst. Zwischen dem ersten Anschluss und dem zweiten

Anschluss ist in einem ersten Strompfad ein Primärschalter der Schalteinrichtung angeordnet. Zudem ist in einem parallel zu dem ersten Strompfad angeordneten zweiten Strompfad ein Sekundärschalter der Schalteinrichtung angeordnet. Zusätzlich ist in einem dritten Strompfad parallel zum Sekundärschalter ein hochohmiger Schaltregler angeordnet. In Reihe zum Sekundärschalter und zum Schaltregler ist parallel zum ersten Strompfad ein niederohmiger Energiespeicher angeordnet. Sowohl der Schaltregler als auch der Energiespeicher dienen zur Bereitstellung der Eigenversorgungsspannung für die Steuerung.

Der Schaltregler ist vorzugsweise ein so genannter "Offline-Schaltregler" mit kleiner Stromaufnahme und insbesondere mit Eingangsspannungen von bis zu 400 V. Der Schaltregler weist insbesondere bei kleinen Strömen von < 5 mA ein effektives Übersetzungsverhältnis von ca. 10 bis 20 auf, so dass zum Beispiel bei einem Strombedarf durch die Schalter-Elektronik mit z.B. einem Funk-Empfänger von 2 mA die Stromaufnahme aus dem Netz und somit über die Last zwischen 100 µA und 200 µA beträgt.

In einer vorteilhaften Ausführung schaltet die Steuerung im ausgeschalteten Zustand den Primärschalter und den Sekundärschalter dauerhaft aus. Dadurch stellt der Schaltregler über den dritten Strompfad die Eigenversorgungsspannung zur Verfügung. Im eingeschalteten Zustand schaltet die Steuerung den Primärschalter und den Sekundärschalter ein. Hierdurch steht im eingeschalteten Zustand zunächst die volle Wechselspannung des Spannungsnetzes der Last zur Verfügung, und anstatt des Schaltreglers stellt der Energiespeicher allein die Eigenversorgungsspannung für die Steuerung zur Verfügung. Bei einem Unterschreiten einer minimalen Versorgungsspannung im eingeschalteten Zustand schaltet die Steuerung den Primärschalter aus. Dadurch wird ein Teil der Wechselspannung des Spannungsnetzes zum Aufladen des Energiespeichers verwendet. Bei einem Erreichen einer maximalen Versorgungsspannung im eingeschalteten Zustand schaltet die Steuerung den Primärschalter wieder ein, wodurch die volle Wechselspannung wieder für die Last zur Verfügung steht.

Dies ermöglicht insbesondere, dass im eingeschalteten Zustand zum Zweck des Nachladens (d. h. Umschaltung vom ersten Strompfad auf den zweiten Strompfad) der Laststrom niemals unterbrochen, sondern, bedingt durch den kleinen Spannungsabfall am Schalter, nur relativ wenig abgesenkt wird. Dies verhindert insbesondere eine unerwünschte Absenkung der Helligkeit bei kleinen Lasten, z. B. LED-Lampen kleiner als 10 W, was insbesondere bei einer reinen Phasen-An/Abschnitt-Steuerung zum Aufladen des Energiespeichers auftreten würde.

Zudem ermöglicht dies, dass die Spannung an der Last während des Nachladens im eingeschalteten Zustand der Last nur minimal gesenkt wird, so dass ein Umschalten des Laststroms vom ersten auf den zweiten Strompfad und zurück vom zweiten auf den ersten Strompfad theoretisch jederzeit ohne größere Stromspitzen in den Kondensator einer kapazitiven Last erfolgen kann. Insofern wird die kapazitive Last geschont.

Der Primärschalter und der Sekundärschalter sind vorzugsweise als N-Kanal-MOSFET ausgebildet. Dies ermöglicht ein relativ langsames Umschalten vom primären auf den sekundären Strompfad, so dass keine schnellen Änderungen am Laststrom entstehen und demzufolge keine Überspannung von der induktiven Last generiert werden kann. Würde eine induktive Last abgeschaltet, während noch eine gewisse Menge an Strom fließt, und das auch noch sehr schnell, würden sehr hohe Spannungsspitzen entstehen, die jegliche angeschlossene Elektronik gefährden können.

Der erfindungsgemäße Schalter hat insbesondere bei gemischten Lasten (induktiv und kapazitiv) den Vorteil, dass sowohl die Lasten als auch der Schalter schonender betrieben werden können. Es kann insbesondere auf weitere Vorsichtsmaßnahmen, wie so genannte "Snubber" oder Varistoren, verzichtet werden.

Insbesondere durch die Verwendung des Schaltreglers kann zusätzlich im ausgeschalteten Zustand des Schalters der benötigte Stromfluss minimiert werden, so dass auch besonders kleine kapazitive Lasten trotz Eigenversorgung des Schalters im ausgeschalteten Zustand verbleiben.

Die Steuerung weist vorzugsweise einen Mikroprozessor auf, der über Ausgangssignale die Schalter der Schalteinrichtung steuert.

In einer weiteren vorteilhaften Ausbildung der Erfindung ist ein Spannungsregler zwischen der Eigenversorgungsspannung und der Steuerung angeordnet und sowohl an dem Energiespeicher und parallel dazu an dem Schaltregler angeschlossen. Dadurch wird die Eigenversorgungsspannung auf einen für die Steuerung idealen Wert stabilisiert. Dadurch kann der zulässige Spannungsbereich am Energiespeicher vergrößert werden, was die Auswahl der verwendbaren Energiespeicher vergrößert und die Steuerung der Zuschaltintervalle des Sekundärschalters flexibler gestaltet.

In einer möglichen Ausführungsform regelt der Spannungsregler die Eigenversorgungsspannung zu einer relativ niedrigeren Versorgungsspannung, insbesondere 3,3 V, für die Steuerung herunter. Insofern kann die Eigenversorgungsspannung am Energiespeicher relativ hoch, insbesondere mindestens 10 V bis maximal 40 V, sein. Dies macht es der Steuerung leichter, einen geeigneten Zeitpunkt zum Beenden des Nachlade-Vorgangs für den Energiespeicher zu ermitteln. Der Energiespeicher kann insbesondere schneller geladen werden. Die Reaktionszeit der Steuerung, ein Überladen des Energiespeichers zu verhindern, kann zudem verlängert werden, so dass die Rechenleistung der Steuerung anders ausgelegt werden kann.

In einer möglichen alternativen Ausführungsform regelt der Spannungsregler die Eigenversorgungsspannung zu einer relativ höheren Versorgungsspannung für die Steuerung herauf. Insofern kann die Eigenversorgungsspannung am Energiespeicher relativ niedrig, insbesondere zwischen 1 V und 2 V, sein. Vorzugsweise wird in diesem Fall zu dem Spannungsregler ein weiterer Schaltregler betrieben, der die Versorgungsspannung, vorzugsweise 3,3 V, für die Steuerung erzeugt. Dadurch ist der Spannungsabfall am Schalter möglichst klein, so dass bei besonders kleinen Lasten, wie zum Beispiel 3 W LED-Lampen, selbst bei einer ungünstigen Wahl der Ladeintervalle durch die Steuerung ein Flackern minimiert oder vermieden werden kann.

In einer weiteren Ausführungsform der Erfindung schaltet eine von der Steuerung unabhängige Begrenzungselektronik bei einem Überschreiten einer maximalen Versorgungsspannung der Eigenversorgung den Primärschalter zwangsweise unabhängig von der Steuerung ein. Dies dient als besonders einfach ausgebildete Schutzschaltung, um Beschädigungen des Energiespeichers zu verhindern, falls die Steuerung mangels ausreichender Reaktionszeit einen Lade-Zyklus nicht schnell genug beenden kann.

Vorteilhafterweise kann über den Schaltregler zusätzlich je nach angeschlossener Last-Art, zum Beispiel bei komplexen Lasten (mehrere angeschlossene LED-Lampen mit unterschiedlichen Leistungen von z. B. 3 W bis 100 W) oder sehr kleinen ohmschen Lasten, auch im eingeschalteten Zustand eine Phasen-An- /Abschnitt-Eigenversorgung zur Verfügung gestellt werden. Der Schaltregler wandelt die beim Phasen-An-Abschnitt relativ hohe, am Schalter abfallende Spannung in die erforderliche Versorgungsspannung für die Steuerung um. Dafür wird von der Steuerung der Sekundärschalter dauerhaft und der Primärschalter in entsprechend kurzen Intervallen innerhalb einer Netzphase ausgeschaltet. Mit einer derartigen optionalen Kombination mit einer Phasen-An/Abschnitt-Eigenversorgung kann insbesondere eine einfache Dimmerfunktion zur Verfügung gestellt werden, wobei durch die Kombination mit dem zweiten Strompfad die vollständige Spannung für die Last im eingeschalteten Zustand zur Verfügung steht, so dass eine maximale Helligkeit erreicht werden kann, was bei herkömmlichen Dimmern mit Phasen-An/Abschnitt-Steuerung nicht der Fall ist.

Vorzugsweise weist der elektronische Schalter ein erstes Detektionsmittel auf, welches die Höhe und/oder Phasenlage des Laststroms bestimmt. Insbesondere weist der Primärschalter zwei getrennte, in Reihe geschaltete Schalter auf, die vorzugsweise beim Wechsel zwischen eingeschaltetem Zustand und ausgeschaltetem Zustand gemeinsam aus- und eingeschaltet werden. Die Schalter sind insbesondere jeweils als N-Kanal-MOSFET ausgebildet. Vorteilhafterweise ist zwischen den in Reihe geschalteten Schaltern des Primärschalters ein Shunt-Widerstand als erstes Detektionsmittel zur Messung des Laststroms in Reihe geschaltet, wobei die über den Shunt-Widerstand abfallende Spannung als Eingangssignal zur Steuerung, insbesondere zu einem A/D-Wandler des Mikroprozessors, geleitet wird.

In einer weiteren vorteilhaften Ausführungsform wird durch ein zweites Detektionsmittel die aktuelle Eigenversorgungsspannung gemessen, die zu einem A/D-Wandler des Mikroprozessors der Steuerung geleitet wird.

Insbesondere weist der elektronische Schalter ein drittes Detektionsmittel auf, welches die Höhe und/oder Phasenlage der Wechselspannung des Spannungsnetzes bestimmt.

Die Detektion aller Ströme und Spannungen sind alternativ mittels A/D-Wandler oder Komparator möglich, wobei die jeweilige Schwelle mittels D/A-Wandler eingestellt wird. Was tatsächlich angewendet wird, hängt von den Möglichkeiten des jeweils eingesetzten Mikroprozessors ab.

In einer weiteren Ausgestaltung der Erfindung weist der elektronische Schalter einen dritten elektrischen Anschluss zum Anschließen eines N-Neutralleiters auf. Der dritte Anschluss für den N-Neutralleiter ist über eine Diode in Flussrichtung mit einem Eingang des Schaltreglers verbunden.

Zudem ist die Bezugsmasse des Energiespeichers und des Schaltreglers über eine Diode in Flussrichtung mit dem dritten Anschluss für den N-Neutralleiter verbunden. Die Last ist somit bei eingeschaltetem Schalter zu den über den ersten Anschluss für den L-Phasenleiter und den dritten Anschluss für den N-Neutralleiter mit der Wechselspannung verbundenen Energiespeicher und Schaltregler parallelgeschaltet. Insofern liegt an der Last im eingeschalteten Zustand immer die volle Wechselspannung an, so dass diese unabhängig von dem Spannungsabfall am Energiespeicher oder Schaltregler ist. Außerdem ist zwischen dem dritten Anschluss für den N-Neutralleiter und der Bezugsmasse des Energiespeichers und des Schaltreglers ein Tertiärschalter angeordnet. Der Tertiärschalter ermöglicht es, dass die Steuerung im ausgeschalteten Zustand des Schalters die Verbindung zwischen dem dritten Anschluss für den N-Neutralleiter und der Bezugsmasse leitend schaltet, damit ein Ruhestrom bei positiver Netzhalbwelle vom ersten Anschluss des L-Phasenleiters kommend in Richtung des dritten Anschlusses für den N-Neutralleiter fließen kann und nicht über die Last L abfließt. Im eingeschaltetem Zustand des Schalters muss der Tertiärschalter geöffnet (hochohmig) sein, damit es keinen Kurzschlussstrom vom ersten Anschluss des L-Phasenleiters über die Bezugsmasse zum dritten Anschluss des N-Neutralleiters gibt. Der Tertiärschalter weist insbesondere ein P-Kanal-MOSFET- Schaltelement auf. Der Tertiärschalter ermöglicht es somit, die Last im ausgeschalteten Zustand bei der Verwendung eines N-Neutralleiters komplett stromfrei zu machen. Dies ermöglicht, einen elektrischen Schalter zur Verfügung zu stellen, der die Vorteile eines N-Leiter-Anschlusses nutzen kann, falls ein N-Leiter-Anschluss in der Montageöffnung des elektronischen Schalters vorhanden ist.

In der vorteilhaften Ausführungsform des elektronischen Schalters kann durch das dritte Detektionsmittel auch ein Anschließen eines N-Leiters an einen dritten Anschluss des elektronischen Leiters detektiert werden.

In einer weiteren Ausführungsform bietet der erfindungsgemäße elektronische Schalter die Möglichkeit, ihn als Dimmer unter Einsatz einer Phasen-An- oder Abschnitts-Funktion, z.B. zur Regelung der Helligkeit eines angeschlossenen Leuchtmittels, einzusetzen. Wird der erfindungsgemäße elektronische Schalter in seiner alternativen Funktion als Dimmer mit 2-Draht-Anschluss genutzt, entfällt der oben beschriebene Nachteil von Dimmern mit herkömmlicher Schaltung. Im dimmenden Betrieb kann er sich aus der Spannung versorgen, die an ihm abfällt, wenn mittels des Primärschalters während jeder Netz-Halbwelle ein Phasen-An- oder -Abschnitt über den ersten Strompfad durchgeführt wird. Dabei bleibt der Sekundärschalter und damit der zweite Strompfad jedoch gesperrt, die Eigenversorgung geschieht mittels des Schaltreglers. Nähert sich die gewünschte Dimmstärke jedoch dem maximalen Helligkeitswert, zum Beispiel unterhalb von 10 % der maximalen Dimmstärke, soll ein z.B. angeschlossenes Leuchtmittel also mit voller Helligkeit betrieben werden, so wird, anstatt weiter zu dimmen, die erfindungsgemäße Schalter-Funktion aktiviert.

Dabei wird die Eigenstromversorgung über den an anderer Stelle beschriebenen Sekundärschalter und den zweiten Strompfad aus dem Laststrom generiert. Wird der Primärschalter und damit der erste Strompfad abgeschaltet, übernimmt der Sekundärschalter und damit der zweite Strompfad kurzzeitig den Laststrom, mit nur minimaler Verringerung der Spannung über der Last. Diese wird während der gesamten Zeit beider Netz-Halbwellen mit Strom versorgt und erreicht, wenn z.B. als Leuchtmittel ausgeführt, eine wesentlich bessere Ausnutzung der maximal möglichen Helligkeit.

Vorteilhafterweise weist der Primärschalter zwei getrennte, in Reihe geschaltete Schalter auf, die beim Dimmen mit leichtem Zeitversatz, insbesondere mit max. 1 ms aus- und eingeschaltet werden. Dies kann sich bei induktiven Lasten vorteilhaft gegen Spannungsspitzen während des Ein- oder Ausschaltvorgangs auswirken.

Als vorteilhaft erweist sich die Tatsache, dass der erfindungsgemäße Schalter für beide Funktionen, sowohl das Schalten als auch das Dimmen, identisch sein kann. Der Primärschalter ist vorzugsweise als Reihenschaltung zweier MOSFETs sowohl für Phasen-An- als auch -Abschnitte geeignet. Der Schaltregler zur Eigenversorgung bei 2-Leiter-Anschluss im ausgeschalteten Zustand kann beim Dimmen die Stromversorgung der Elektronik in den Phasen-An- oder -Abschnitten gewährleisten. Der Sekundärschalter bzw. der zweite Strompfad erlauben eine vorteilhafte Funktion der Schaltung im Dimmer-Betrieb bei maximaler Einstellung, ohne wesentlichen Helligkeitsverlust eines z.B. angeschlossenen Leuchtmittels. Welche Funktion die hier beschriebene Elektronik ausführt, ob Schalter, Dimmer oder kombiniert, kann durch eine entsprechendes Verfahren in der Steuerung bestimmt werden.

Weitere vorteilhafte Ausgestaltungen der Erfindung ergeben sich aus der folgenden Figurenbeschreibung und den abhängigen Unteransprüchen.

Es zeigen:
- Fig. 1: eine systematische Darstellung einer ersten Ausführungsform eines elektronischen Schalters,
- Fig. 2: eine beispielhafte elektronische Schaltung für eine Erweiterung mit Begrenzungselektronik und Puffer-Komparator,
- Fig. 3: eine systematische Darstellung einer Erweiterung eines elektronischen Schalters mit einem dritten Anschluss für einen N-Neutralleiter,
- Fig. 4: eine beispielhafte elektronische Schaltung für die Überwachung des Laststroms, und
- Fig. 5: eine beispielhafte elektronische Schaltung für ein Detektionsmittel zur Bestimmung der Höhe und/oder Phasenlage der Wechselspannung des Spannungsnetzes.

In den verschiedenen Figuren der Zeichnung sind gleiche Teile stets mit denselben Bezugszeichen versehen.

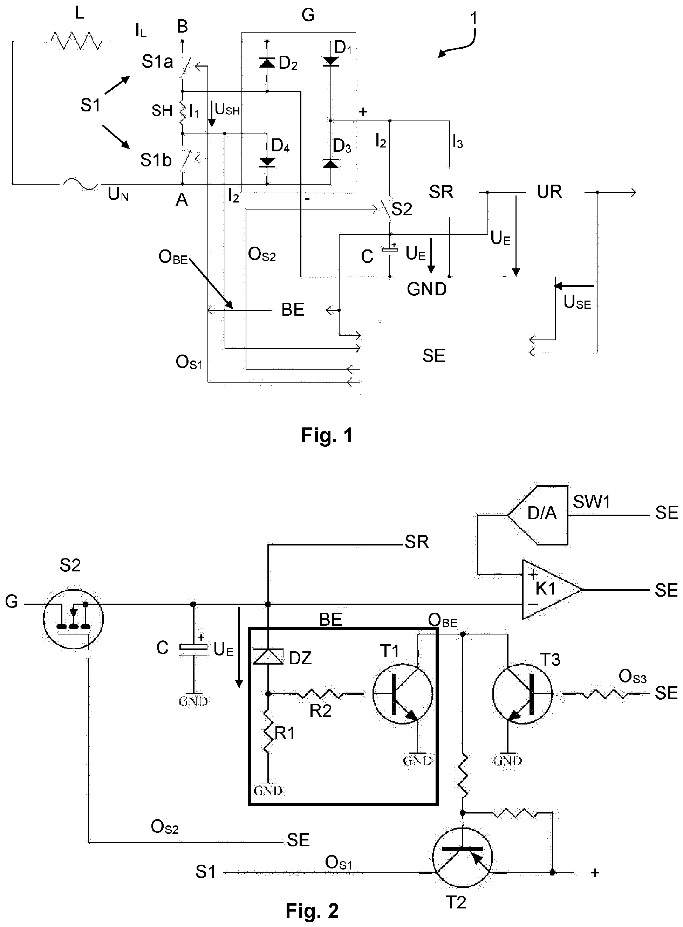

In Fig. 1 ist eine systematische Darstellung einer ersten Ausführungsform eines elektronischen Schalters 1 für die Elektroinstallationstechnik dargestellt. Der elektronische Schalter 1 weist einen ersten elektrischen Anschluss A zum Anschließen eines L-Phasenleiters einer Wechselspannung UN eines Spannungsnetzes und einen zweiten elektrischen Anschluss B zum Anschließen einer elektrischen Last L auf. Zudem weist der elektronische Schalter 1 eine elektronische Schalteinrichtung zum Schalten der Last L zwischen einem eingeschalteten Zustand ON und einem ausgeschalteten Zustand OFF auf. Zusätzlich können auch weitere Funktionen, wie zum Beispiel ein Dimmen der Last L, vorgesehen sein. Der elektronische Schalter 1 weist außerdem eine elektronische Steuerung SE zum Ansteuern der Schalteinrichtung auf. Zusätzlich weist der elektronische Schalter 1 Mittel für eine interne Eigenversorgungsspannung UE für die Steuerung SE unter Verwendung eines durch die Last L fließenden Laststroms IL auf.

Zwischen dem ersten Anschluss A und dem zweiten Anschluss B des elektronischen Schalters 1 ist in einem ersten Strompfad I₁ ein Primärschalter S1 der Schalteinrichtung angeordnet. Zudem ist zwischen dem ersten Anschluss A und dem zweiten Anschluss B in einem parallel zu dem ersten Strompfad I₁ angeordneten zweiten Strompfad I₂ ein Sekundärschalter S2 der Schalteinrichtung angeordnet. In dem zweiten Strompfad I₂ ist insbesondere ein Gleichrichter G, wie dargestellt vorzugsweise aus vier Dioden D1, D2, D3, D4, angeordnet. Vorzugsweise werden zwei Dioden D2, D4 aus den Body-Dioden des als vorteilhafterweise durch zwei MOSFET-Transistoren ausgebildeten Primärschalters S1 gebildet. Außerdem ist parallel zum Sekundärschalter S2 in einem dritten Strompfad I₃ ein hochohmiger Schaltregler SR zur Bereitstellung der Eigenversorgungsspannung UE angeordnet. Ein Energiespeicher C ist in Reihe zu dem Sekundärschalter S2 und in Reihe zu dem Spannungsausgang des Schaltreglers SR und parallel zum ersten Strompfad I₁ geschaltet. Der Energiespeicher C ist vorzugsweise, wie dargestellt, als ein niederohmiger Puffer-Kondensator ausgebildet. Der Energiespeicher C und der Schaltregler SR sind zudem an die Bezugsmasse GND angeschlossen. Die Bezugsmasse GND ist insbesondere mit einem Minuspol des Gleichrichters G verbunden.

In der dargestellten vorteilhaften Ausführungsform ist zwischen der Eigenversorgungsspannung U_{E} und der Steuerung SE ein Spannungsregler UR angeordnet, der an dem Energiespeicher C und parallel dazu an dem Spannungsausgang des Schaltreglers SR angeschlossen ist. In einer ersten möglichen Ausführungsform regelt der Spannungsregler UR die Eigenversorgungsspannung U_{E} zu einer relativ niedrigeren Versorgungsspannung U_{SE} für die Steuerung SE herunter. In einer alternativen Ausführungsform regelt der Spannungsregler UR die Eigenversorgungsspannung U_{E} zu einer relativ höheren Versorgungsspannung U_{SE} für die Steuerung SE herauf.

Die Steuerung SE weist insbesondere einen Mikroprozessor auf, der über Ausgangssignale die Schalter, insbesondere den Primärschalter S1 und den Sekundärschalter S2, der Schalteinrichtung steuert. Der Primärschalter S1 weist, wie dargestellt, insbesondere zwei getrennte, in Reihe geschaltete Schalter S1a, S1b auf, die vorzugsweise beim Wechsel zwischen eingeschaltetem Zustand und ausgeschaltetem Zustand gemeinsam aus- und eingeschaltet werden.

In der dargestellten vorteilhaften Ausgestaltung ist ein erstes Detektionsmittel vorgesehen, welches die Höhe und/oder Phasenlage des Laststroms I_{L} im ersten Strompfad I₁ bestimmen kann. Dazu ist zwischen den in Reihe geschalteten Schaltern S1a, S1b des Primärschalters S1 ein Shunt-Widerstand SH zur Messung des durch den ersten Strompfad I₁ fließenden Teil des Laststroms I_{L} durch die Steuerung SE in Reihe geschaltet. Die über den Shunt-Widerstand SH abfallende Spannung U_{SH} ist als Eingangssignal zur Steuerung SE geleitet. Zudem wird durch ein zweites Detektionsmittel die Eigenversorgungsspannung U_{E} als Eingangssignal an die Steuerung SE geleitet.

In der in Fig. 1 dargestellten vorteilhaften Ausgestaltung ist eine von der Steuerung SE unabhängige Begrenzungselektronik BE ausgebildet, die bei einer maximalen Versorgungsspannung U_{Emax} durch die aktuelle Eigenversorgungsspannung U_{E} den Primärschalter S1 zwangsweise unabhängig von der Steuerung SE einschaltet. Damit wird der Energiespeicher vor einer Überladung geschützt.

Fig. 2 zeigt eine vorteilhafte Ausführungsform und mögliche Integration einer derartigen Begrenzungselektronik BE. Die Begrenzungselektronik BE umfasst insbesondere einen Begrenzungstransistor T1, eine Zenerdiode DZ und zwei Widerstände R1, R2. Durch eine passende Auslegung einer Zenerspannung der Zenerdiode DZ wird bei einem Überschreiten der aktuellen Eigenversorgungsspannung U_{E} über eine maximale Versorgungsspannung U_{Emax} ein Schalttransistor T2 mit dem Ausgangssignal O_{BE} der Begrenzungselektronik BE angesteuert, der dann das Ausgangssignal O_{S1} an den Primärschalter S1 ausgibt und damit den Primärschalter S1 schließt. Alternativ könnte auch ein einfacher Spannungsteiler aus Widerständen eingesetzt werden, dabei würde aber ständig ein Strom durch die Widerstände des Spannungsteilers fließen. Durch die Zenerdiode DZ fließt aber erst ein Strom, sobald die Zenerspannung überschritten wird, ansonsten verbraucht die Anordnung vorteilhafterweise nur einen zu vernachlässigenden kleinen Strom, insbesondere einen Strom < 1µA. Gleichzeitig kann der Schalttransistor T2 auch von dem Transistor T3 angesteuert werden. Der Transistor T3 wird direkt von der Steuerung SE mit dem Ausgangssignal O_{S3} angesteuert, so dass der Schalttransistor T2 das Ausgangssignal O_{S1} an den Primärschalter S1 weiterleitet.

Zudem zeigt Fig. 2 insbesondere eine vorteilhafte Integration eines Puffer-Komparators K1 und eines Digital/Analog-Konverters D/A. Mittels des Digital/Analog-Konverters D/A wird die Eigenversorgungsspannung U_{E} des Energiespeichers C mit einem Schwellenwert SW1 verglichen und das Ergebnis am Puffer-Komparator K1 ausgegeben. Vorzugsweise wird der Schwellenwert SW1 von der Steuerung SE festgelegt und das Ergebnis am Puffer-Komparator K1 an die Steuerung SE übertragen.

Der Puffer-Komparator K1 kommt insbesondere beim Nachladen zum Einsatz. Er erkennt bei einem niedrigen Schwellwert SW1 den niedrigsten Ladezustand des Energiespeichers C. Sobald dieser erreicht ist, muss schnellstmöglich nachgeladen werden. Die dem Puffer-Komparator K1 zugeführte Eigenversorgungsspannung U_{E} vom Energiespeicher C wird beispielhaft im Verhältnis 1/3 geteilt. Bei einer minimal erlaubten Ladung des Energiespeichers C von beispielhaft ca. 4V wird der Schwellwert SW1 des Puffer-Komparators K1 entsprechend auf beispielhaft ca. 1,3V eingestellt.

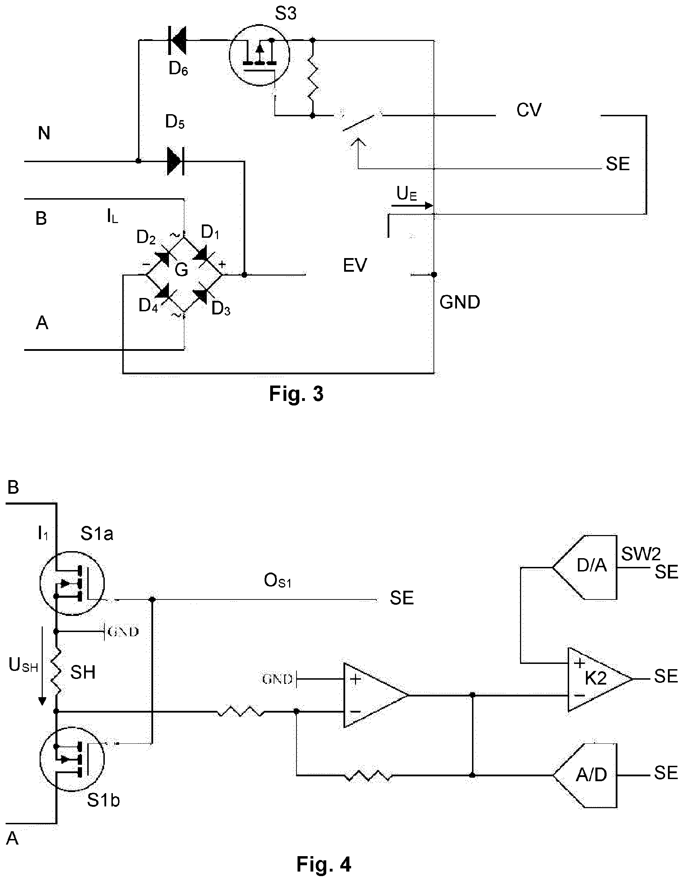

Fig. 3 zeigt eine beispielhafte Erweiterung einer vorteilhaften Ausführungsform eines elektrischen Schalters mit einem dritten elektrischen Anschluss N zum Anschließen eines N-Neutralleiters. Dabei ist ein Großteil der in Fig. 1 beschriebenen Elektronik hier vereinfacht als Eigenversorgungsschaltelektronik EV zusammengefasst. Der Anschluss N ist über eine Diode D5 in Flussrichtung mit den Eingängen der Eigenversorgungsschaltelektronik EV, insbesondere entsprechend Fig. 1 mit dem Eingang des Schaltreglers SR verbunden. Zudem ist die Bezugsmasse GND des Energiespeichers C und die Bezugsmasse GND des Schaltreglers SR über eine Diode D6 in Flussrichtung mit dem Anschluss N verbunden. Die Last L ist somit im eingeschalteten Zustand ON zu der über den Anschluss A und Anschluss N mit der Wechselspannung U_{N} verbundenen Eigenversorgungsschaltelektronik EV parallelgeschaltet. Insofern liegt an der Last L im eingeschalteten Zustand ON immer die volle Wechselspannung U_{N} an, so dass diese unabhängig von der Eigenversorgungsschaltelektronik EV ist. Um die Last L im ausgeschalteten Zustand OFF komplett stromfrei zu machen, wird vorteilhafterweise über einen Tertiärschalter S3 die Verbindung zwischen dem Anschluss N und der Bezugsmasse der Eigenversorgungsschaltelektronik EV, d. h. zwischen der Bezugsmasse GND des Energiespeichers C und der Bezugsmasse GND des Schaltreglers SR, leitend geschaltet. Dies ermöglicht, einen elektrischen Schalter zur Verfügung zu stellen, der die Vorteile eines N-Leiter-Anschlusses nutzen kann, falls ein N-Leiter-Anschluss in der Montageöffnung des elektronischen Schalters vorhanden ist. Der Tertiärschalter S3 ist vorteilhafterweise vom P-kanal-Typ (MOSFET oder Transistor) und braucht daher eine negative Steuerspannung. Ein Spannungskonverter CV setzt die positive Eigenversorgungsspannung U_{E} der Eigenversorgung EV in eine negative Spannung zur Ansteuerung des Tertiärschalters S3 um.

Fig. 4 zeigt eine vorteilhafte Ausführungsform und mögliche Integration einer Laststromüberwachung, insbesondere unter Verwendung der bereits oben beschriebenen ersten Detektionsmittel. Die Laststromüberwachung weist insbesondere einen Laststrom-Komparator K2 und einen Digital/Analog-Konverter D/A auf. Mittels des Digital/Analog-Konverters D/A wird der durch den ersten Strompfad I₁ fließende Teil des Laststroms I_{L} mit einem Schwellenwert SW2 verglichen und das Ergebnis am Laststrom-Komparator K2 ausgegeben.

Vorzugsweise wird der Schwellenwert SW2 von der Steuerung SE festgelegt und das Ergebnis am Laststrom-Komparator K2 an die Steuerung SE übertragen. Zudem weist die Laststromüberwachung einen Analog/Digital-Konverter A/D auf, der den durch den ersten Strompfad I₁ fließenden Teil des Laststroms I_{L} von analog nach digital wandelt und an die Steuerung SE überträgt, so dass die Phase beziehungsweise der Nulldurchgang des Laststroms I_{L} von der Steuerung SE detektiert werden kann. Die von dem ersten Detektionsmittel gemessene Spannung wird insbesondere über einen Operationsverstärker verstärkt und an den Laststrom-Komparator K2 und/oder den Analog/Digital-Konverter A/D übertragen.

Die niedrige Schwelle SW2 des Laststrom-Komparators K2 beim Nachladen wird vorteilhafterweise zur Erkennung eines Nulldurchgangs des Laststromes I_{L} benutzt. Theoretisch ist beim Nulldurchgang die Spannung am Shunt-Widerstand SH und damit auch am Laststrom-Komparator K2 gleich 0V. Der Schwellwert SW2 wird jedoch auf einen etwas höheren Wert, z.B. wenige Millivolt, eingestellt. Zum einen werden damit Störungen rund um den Nullpunkt ausgeblendet und Verzögerungen durch Programmlaufzeiten ausgeglichen. Es wird also praktisch der Zeitpunkt kurz vor dem Nulldurchgang ermittelt. Die Steuerung SE hat dann etwas Zeit zu reagieren, um den tatsächlichen Nulldurchgang anschließend bestmöglich zu treffen. Auch das Abschalten des Primärschalters S1 benötigt eine gewisse Zeit. Mittels der Komparator-Schwelle SW2 des Laststrom-Komparators K2 lässt sich die Zeit zwischen der Erkennung und dem tatsächlichen Nulldurchgang in Abhängigkeit von der erkannten Lastart einstellen.

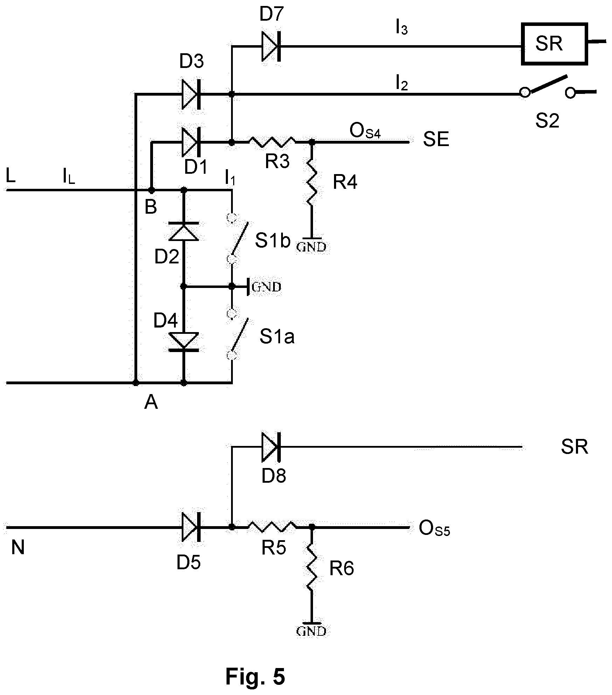

Fig. 5 zeigt eine beispielhafte Ausführungsform eines dritten Detektionsmittels eines erfindungsgemäßen elektronischen Schalters zur Bestimmung der Höhe und/oder Phasenlage der Wechselspannung U_{N} des Spannungsnetzes. Das dritte Detektionsmittel ist vorzugsweise am Ausgang des Gleichrichters, insbesondere hinter den Dioden D1 und D3 des Gleichrichters in Reihe angeordnet und stellt ein Signal O_{S4} für die Steuerung SE zur Verfügung. Das Signal O_{S4} wird insbesondere zu einem A/D-Wandler des Mikroprozessors geleitet. Dazu umfasst das dritte Detektionsmittel zwei strombegrenzende, in Reihe geschaltete Widerstände R3 und R4, wobei das Signal O_{S4} für die Steuerung SE zwischen den beiden Widerständen R3 und R4 abgegriffen wird. Zudem ist zwischen dem dritten Detektionsmittel und dem Schaltregler SR eine weitere Diode D7 angeordnet, die vom Schaltregler in Richtung des dritten Detektionsmittels beziehungsweise in Richtung der Bezugsmasse GND sperrt. Die Diode D7 entkoppelt insbesondere den spannungsgepufferten Eingang des Schaltreglers SR von dem Signal O_{S4}, da sich die gepufferte Spannung sonst den Nulldurchgängen überlagern würde. Das dritte Detektionsmittel kann insbesondere sowohl in einer Ausführungsform ohne einen dritten Anschluss N für einen N-Leiter, beispielhaft gemäß Fig. 1, oder auch in einer Ausführungsform mit einem dritten Anschluss N für einen N-Leiter, beispielhaft gemäß Fig. 3., ausgebildet sein.

Bei der vorteilhaften Ausführungsform des elektrischen Schalters gemäß Fig. 3 mit zusätzlichem N-Leiter Anschluss N, wird vorzugsweise hinter der Diode D5, die hinter dem Anschluss N des N-Leiters angeordnet ist, ein Signal O_{S3} für die Steuerung SE zur Verfügung gestellt. Das Signal O_{S5} wird insbesondere zu einem A/D-Wandler des Mikroprozessors geleitet. Dazu umfasst das dritte Detektionsmittel zwei strombegrenzende, in Reihe geschaltete Widerstände R5 und R6 hinter der Diode D5, die hinter dem Anschluss N des N-Leiters angeordnet ist, wobei das Signal O_{S5} für die Steuerung SE zwischen den beiden Widerständen R5 und R6 abgegriffen wird. Zudem ist zwischen dem dritten Detektionsmittel und dem Schaltregler SR eine weitere Diode D8 angeordnet, die vom Schaltregler in Richtung des dritten Detektionsmittels beziehungsweise in Richtung der Bezugsmasse GND sperrt. Die Diode D8 entkoppelt insbesondere den spannungsgepufferten Eingang des Schaltreglers SR von dem Signal O_{S5}, da sich die gepufferte Spannung sonst den Nulldurchgängen überlagern würde. Dadurch kann mit dem dritten Detektionsmittel neben der Höhe und/oder Phasenlage der Wechselspannung U_{N} auch grundsätzlich ein Anschließen eines N-Leiters erkannt werden und entsprechend der Steuerungsablauf für die Eigenversorgung angepasst werden.

Der elektronische Schalter 1 weist ein von einer Person betätigbares Betätigungselement auf. Das Betätigungselement kann zum Beispiel elektromechanisch oder elektronisch in Form einer Schaltwippe oder eines Tasters, elektrostatisch in Form eines elektrostatischen Sensors, optisch in Form einer Kamera oder eines IR-Sensors, oder akustisch in Form eines Mikrofons funktional ausgebildet sein. Die Steuerung SE erfasst den aktuellen Zustand und/oder eine Zustandsänderung des Betätigungselementes und weist diesen eine Bedeutung zu, zum Beispiel den eingeschalteten Zustand ON oder ausgeschalteten Zustand OFF.

Für ein Ein- bzw. Ausschalten des elektronischen Schalters wird vorteilhafterweise zunächst die Betätigung des Betätigungselementes detektiert und in Abhängigkeit vom aktuellen Zustand entschieden, ob eingeschaltet oder ausgeschaltet wird.

Im Folgenden werden vorteilhafte Verfahren beziehungsweise ein bevorzugter Steuerungsablauf in der Steuerung SE beschrieben. Der Steuerungsablauf ist bevorzugt als Software in der Steuerung SE realisiert und wird in einer Steuerungsschleife wiederholt durchlaufen:
Im ausgeschalteten Zustand OFF des elektronischen Schalters hat die Steuerung SE den Primärschalter S1 und den Sekundärschalter S2 dauerhaft ausgeschaltet, so dass der Schaltregler SR über den dritten Strompfad I₃ die Eigenversorgungsspannung U_{E} zur Verfügung stellt.

Bei Übergang vom ausgeschalteten Zustand OFF in den eingeschalteten Zustand ON des elektronischen Schalters schaltet die Steuerung SE zunächst den Primärschalter S1 und den Sekundärschalter S2 ein.

Insbesondere wird zunächst der Primärschalter S1 und danach der Sekundärschalter S2 eingeschaltet. Vorzugsweise wartet die Steuerung SE vor dem Einschalten des Sekundärschalters S2 und des Primärschalters S1 ab, bis sich die Wechselspannung U_{N} im Nulldurchgang befindet. Dabei wird vorteilhafterweise ein Timer auf die Netzspannungsphase synchronisiert. Zur Bestimmung des Nulldurchgangs der Wechselspannung U_{N} wird insbesondere das oben beschriebene dritte Detektionsmittel verwendet.

Die Last L wird mit der vollen Wechselspannung U_{N} versorgt und der vorher durch einen weiter unten beschriebenen Ladeablauf aufgeladene Energiespeicher C stellt die Eigenversorgungsspannung U_{E} für die Steuerung SE zur Verfügung. Bei einem Unterschreiten einer minimalen Versorgungsspannung U_{Emin} am Energiespeicher C schaltet die Steuerung SE den Primärschalter S1 aus, so dass ein kleiner Teil der Wechselspannung U_{N} zum Aufladen des Energiespeichers C genutzt wird, wobei der größere Teil der Wechselspannung U_{N} weiterhin die Last L versorgt, bis bei einem Erreichen einer maximalen Versorgungsspannung U_{Emax} am Energiespeicher C die Steuerung SE den Primärschalter S1 wieder einschaltet, so dass die Last L wieder mit der vollen Wechselspannung U_{N} versorgt wird. Zur Bestimmung, ob die maximale Versorgungsspannung U_{Emax} erreicht ist, wird insbesondere das oben beschriebene zweite Detektionsmittel verwendet.

Für den Fall, dass von dem eingeschalteten Zustand ON in den ausgeschalteten Zustand OFF übergegangen werden soll, wird von der Steuerung SE vorzugsweise zunächst überprüft, ob der Energiespeicher C ausreichend aufgeladen ist, d. h. insbesondere ob die aktuelle Eigenversorgungsspannung U_{E} der maximalen Versorgungsspannung U_{Emax}, entspricht. Dies ermöglicht, eine mögliche Verzögerung des Schaltreglers SR für eine Spannungserzeugung im ausgeschalteten Zustand OFF zu überwinden. Für den Fall, dass der Energiespeicher C nicht ausreichend aufgeladen ist, wird dieser zunächst in einem weiter unten beschriebenen Nachladeablauf nachgeladen.

Bei ausreichend aufgeladenem Energiespeicher C werden der Sekundärschalter S2 und der Primärschalter S1 ausgeschaltet, womit der Übergang in den ausgeschalteten Zustand OFF abgeschlossen ist. Insbesondere wird zunächst der Sekundärschalter S2 und danach der Primärschalter S1 ausgeschaltet. Vorzugsweise wartet die Steuerung SE vor dem Ausschalten des Sekundärschalters S2 und des Primärschalters S1 ab, bis sich der Laststrom I_{L} im Nulldurchgang befindet. Dazu wird insbesondere das oben beschriebene erste Detektionsmittel von der Steuerung SE verwendet. In einer weiteren vorteilhaften Ausführungsform wird zunächst der Sekundärschalter S2 ausgeschaltet und der Primärschalters S1 erst beim Nulldurchgang des Laststroms I_{L} ausgeschaltet.

In einer vorteilhaften Ausgestaltung wird in der Steuerung SE eine Lasterkennung zur Bestimmung der Lastart, insbesondere ob die Last L eine ohmsche, induktive oder kapazitive Last L ist und/oder wie groß die Last L ist, durchgeführt. Anhand der bestimmten Lastart kann eine für die jeweilige Lastart optimierte Nachladestrategie während des weiter unten beschriebenen Nachladeablaufs ausgewählt werden. In einer bevorzugten Ausführungsform der Lasterkennung wird über die Detektionsmittel eins und drei ein Phasenversatz zwischen Strom und Spannung detektiert und dadurch die Lastart bestimmt. Die Lastarterkennung kann insbesondere nur einmalig beim erstmaligen Einschalten des Schalters mit angeschlossener Lastart erfolgen oder bei jedem Einschalten, um Lastwechsel im ausgeschalteten Zustand OFF zu erkennen.

Im Folgenden wird ein bevorzugter Ablauf einer Lasterkennung beschrieben:
Bei der Lasterkennung ist zumindest der Primärschalter S1 und damit die Last L eingeschaltet. Insbesondere wird zunächst der Schwellwert SW2 des Laststrom-Komparators K2 auf eine niedrige Schwelle gesetzt. Mit "niedriger Schwelle" ist vorteilhafterweise ein Wert gemeint, den kleine Lasten L, insbesondere mit 50W oder weniger, gerade noch nicht überschreiten. Diese kleine Lasten L werden beim Nachladen insofern anders als größere Lasten L behandelt, so dass der Energiespeicher C nicht erst dann nachgeladen wird, wenn er fast leer ist.

Vorzugsweise wird eine Wahrscheinlichkeit für das Vorhandensein einer kapazitiven Last L ermittelt. Insbesondere wird ermittelt, ob die Stromaufnahme kontinuierlich und gleichmäßig über die Netzphase aufgenommen wird, oder eher nur kurz bzw. stoßweise im Scheitel der Netzspannung. Ist dies der Fall, ist von einer kapazitiven Last auszugehen.

Dazu wird insbesondere das Tastverhältnis des Laststroms I_{L}, insbesondere aus den digitalen Laststrom Werten des Analog/Digital-Konverters A/D (siehe Fig. 4) ermittelt. Dazu wird der Verlauf des Laststroms I_{L} mittels A/D-Konverter kontinuierlich in digitale Werte umgeformt und von der Steuerung SE untersucht.

Alternativ ist die Ermittlung des Verlaufes der Stromaufnahme mittels Komparator möglich. Dazu muss mehrfach während der Netzphase die Komparator-Schwelle verändert werden und es muss versucht werden, daraus den Verlauf des Laststromes abzuleiten. Vorzugsweise kann auch mit mehreren Komparatoren parallel mit jeweils unterschiedlichen Schwellen gearbeitet werden.

Vorzugsweise wird anschließend eine Wahrscheinlichkeit für das Vorhandensein einer induktiven Last ermittelt. Dazu wird insbesondere ein Phasenvergleich des Laststroms I_{L} und der Wechselspannung U_{N} basierend auf dem oben bestimmten Timer der Netzspannungsphase durchgeführt. Für den Fall, dass ein N-Leiter an dem Anschluss N angeschlossen ist, wird alternativ ein Phasenvergleich zwischen dem Laststrom I_{L} und der N-Leiter Spannung durchgeführt. Anschließend wird auf Basis der oben abgeschätzten Wahrscheinlichkeiten eine Lastart bestimmt.

Im Folgenden wird ein bevorzugter Nachladeablauf beschrieben. Der Nachladeablauf ist Teil des Steuerungsablaufs und ebenfalls bevorzugt als Software in der Steuerung SE realisiert und wird in Abhängigkeit einer Nachlade-Zyklus-Frequenz so oft wie möglich pro Sekunde durchlaufen, bis der Nachladeablauf explizit abgebrochen wird:
Zum Nachladen ist der Sekundärschalter S2 eingeschaltet. Vorzugsweise entscheidet die Steuerung SE basierend auf der erkannten Lastart, ob für die Last L ein längerer Nachlade-Zyklus, insbesondere mit einer Frequenz kleiner als 25 Hz, möglich ist. Dies ist für die meisten Lasten möglich. Lediglich sehr kleine und insbesondere kleine kapazitive Lasten L benötigen einen sehr kurzen Nachlade-Zyklus, insbesondere mit Frequenzen zwischen 25 Hz und 100 Hz.

Vorzugsweise wird der Primärschalter S1 zum Nachladen jeweils in jeder Halbwelle abgeschaltet und, wenn die Eigenversorgungsspannung U_{E} im Energiespeicher C die maximale Versorgungsspannung U_{Emax} erreicht, wieder eingeschaltet. Das verhindert ein vom Menschen erkennbares Flackern bei kleineren Lasten L, während ein wahrnehmbares Flackern bei größere Lasten L nicht auftritt. Bei größeren angeschlossenen Lasten L über z.B. 50W wird nur nachgeladen, wenn der Energiespeicher C fast leer ist, entsprechend z.B. nur 3-mal / Sekunde. Beispielhaft entsprechen 50W ca. 200mA Laststrom I_{L}, entsprechend insbesondere einem Spannungsabfall von ca. 20mV am Shunt-Widerstand SH. Diese Spannung wird zur Messung beispielsweise um ca. den Faktor 10 verstärkt. Der Schwellwert SW2 am Laststrom-Komparator K2 wird dementsprechend auf ca. 200mV eingestellt.

Ist ein längerer Nachlade Zyklus, insbesondere mit einer Frequenz < 25 Hz, in Abhängigkeit von der durch die Lasterkennung erkannten Lastart möglich, so wird zunächst überprüft, ob die Eigenversorgungsspannung U_{E} des Energiespeichers C unter eine minimale Versorgungsspannung U_{Emin}, gefallen ist. Die minimale Versorgungsspannung U_{Emin} ist insbesond ere abhängig von den Spannungsanforderungen der Steuerung SE und/oder anderen verwendeten elektronischen Komponenten im Schalter. Dazu ist vorzugsweise der Puffer-Komparator K1 auf einen niedrigen Schwellwert SW1 gesetzt, so dass der niedrigste erlaubte Ladezustand, d. h. die minimale Versorgungsspannung U_{Emin}, detektiert wird (z.B. ca. 4V). Ist dieser noch nicht erreicht oder nicht unterschritten, wird der Nachladeablauf beendet. Wenn dieser jedoch erreicht oder unterschritten wurde, dann wird der Nachladeablauf fortgeführt, indem der Primärschalter S1 von der Steuerung SE ausgeschaltet wird, so dass der Energiespeicher C geladen wird.

Ist dagegen ein kürzerer Nachlade-Zyklus, insbesondere ≥ 25 Hz, in Abhängigkeit von der durch die Lasterkennung erkannten Lastart erforderlich, so wird vorzugsweise unabhängig vom Zustand des Energiespeichers C nachgeladen, d.h. der Primärschalter S1 von der Steuerung SE ausgeschaltet. In diesem Fall ist davon auszugehen, dass seit dem letzten Nachladevorgang zumindest ein kleiner Teil der Ladung des Energiespeichers C verbraucht wurde. Vorteilhafterweise wird in jeder Halbwelle der Wechselspannung U_{N} nachgeladen. Der Nachladevorgang endet, wenn in der letzten Halbwelle die maximale Versorgungsspannung U_{Emax} erreicht wurde, ansonsten setzt sich der Nachladevorgang über die weiteren Halbwellen fort.

Vorzugsweise wird nach der Bestimmung des Nachlade-Zyklus und vor Beginn des Nachladevorgangs überprüft, ob die bestimmte Lastart einen Start des Nachladens im Nulldurchgang des Laststroms I_{L} erfordert. Dies ist insbesondere bei bestimmten Lastarten beziehungsweise ab einer bestimmten Last-Größe vorteilhaft, die mit dem oben beschriebenen Verfahren der Lasterkennung ermittelt wurden. Ist ein Nulldurchgang des Laststroms I_{L} erforderlich, so wird zunächst der Nulldurchgang abgewartet. Ist dies nicht erforderlich, so kann der Nachladeablauf sofort weitergeführt werden und der Primärschalter S1 von der Steuerung SE ausgeschaltet werden, so dass der Nachladevorgang gestartet wird. Bei kleinen Lasten L muss nicht unbedingt auf den Nulldurchgang des Laststromes I_{L} gewartet werden, da die Umleitung des Laststroms I_{L} durch den Energiespeicher C bei kleinen Lasten L relativ unkritisch ist und zu jedem Zeitpunkt erfolgen kann. Bei größeren Lasten L sollte zur Schonung aller Bauteile der Ladevorgang bzw. die Umleitung des Laststromes I_{L} durch den Energiespeicher C im Nulldurchgang des Laststromes I_{L} begonnen werden.

Vorzugsweise setzt die Steuerung SE den Puffer-Komparator K1 auf einen hohen Schwellwert SW1 und es wird so lange nachgeladen, bis die Eigenversorgungsspannung U_{E} des Energiespeichers C den hohen Schwellwert SW1 am Puffer-Komparator K1 erreicht hat. Während des Nachladens muss der Puffer-Kondensator K1 auf maximal erlaubte Spannung überwacht werden. Ist diese erreicht, wird das Nachladen beendet. Wie erwähnt wird die Spannung am Energiespeicher C beispielhaft mit dem Faktor 1/3 an den Puffer-Komparator K1 geleitet. Soll das Nachladen bei z.B. 6V beendet werden, so ist der Schwellwert SW1 auf ca. 2V einzustellen.

Nach einem Erreichen des hohen Schwellwerts SW1 am Puffer-Komparator K1 wird von der Steuerung SE der richtige Zeitpunkt zum Beenden des Nachladens ausgewählt. Dazu entscheidet die Steuerung SE zunächst anhand der bestimmten Lastart, ob ein Beenden des Nachladens vorzugsweise im Nulldurchgang des Laststroms I_{L} erfolgen soll. Falls dies der Fall ist, wartet die Steuerung SE bis zum Nulldurchgang des Laststroms I_{L}. Falls dies nicht der Fall ist, schaltet die Steuerung SE in Verbindung mit einer Abfrage des Laststrom-Komparators den Primärschalter S1 wieder ein, womit der Nachladeablauf beendet wird.

### Bezugszeichenliste

- 1: Elektronischer Schalter
- A: Anschluss L-Phasenleiter
- A/D: Analog/Digital Konverter
- B: Anschluss Last
- BE: Begrenzungselektronik
- C: Energiespeicher
- CV: Spannungs-Konverter
- D1: erste Diode des Gleichrichters
- D2: zweite Diode des Gleichrichters
- D3: dritte Diode des Gleichrichters
- D4: vierte Diode des Gleichrichters
- D5: Diode
- D6: Diode
- D7: Diode
- D8: Diode
- DZ: Zenerdiode
- D/A: Digital/Analog Konverter
- EV: Eigenversorgungsschaltelektronik
- G: Gleichrichter
- GND: Bezugs-Masse
- I_{L}: Laststrom
- I₁: Erster Strompfad
- I₂: Zweiter Strompfad
- I₃: Dritter Strompfad
- K1: Puffer-Komparator
- K2: Laststrom-Komparator
- L: Last
- N: Anschluss N-Leiter
- R1: Widerstand
- R2: Widerstand
- S1: Primärschalter
- S1a: Schalter des Primärschalters
- S1b: Schalter des Primärschalters
- S2: Sekundärschalter
- S3: Tertiärschalter
- SE: Steuerung
- SH: Shunt-Widerstand
- SR: Schaltregler
- SW1: Schwellwert Puffer-Komparator
- SW2: Schwellwert Laststrom-Komparator
- O_{S1}: Ausgangssignal für S1
- O_{S2}: Ausgangssignal für S2
- O_{S3}: Ausgangssignal für T3
- O_{S4}: Eingangssignal für SE
- O_{BE}: Ausgangssignal Begrenzungselektronik für S1
- T1: Begrenzungstransistor
- T2: Schalttransistor
- T3: Transistor
- U_{N}: Wechselspannung des Spannungsnetzes
- U_{E}: Eigenversorgungsspannung
- U_{SE}: Versorgungsspannung Steuerung
- U_{SH}: Über den Shunt-Widerstand abfallende Spannung
- UR: Spannungsregler

## Patentansprüche

1. Elektronischer Schalter (1) der Elektroinstallationstechnik, aufweisend einen ersten elektrischen Anschluss (A) zum Anschließen eines L-Phasenleiters einer Wechselspannung (U_{N}) eines Spannungsnetzes, einen zweiten elektrischen Anschluss (B) zum Anschließen einer elektrischen Last (L), eine elektronische Schalteinrichtung zumindest zum Schalten der Last (L) zwischen einem eingeschalteten Zustand (ON) und einem ausgeschalteten Zustand (OFF), eine elektronische Steuerung (SE) zum Ansteuern der Schalteinrichtung, und Mittel für eine interne Eigenversorgungsspannung (U_{E}) für die Steuerung (SE) unter Verwendung eines durch die Last (L) fließenden Laststroms (I_{L}), wobei zwischen dem ersten Anschluss (A) und dem zweiten Anschluss (B) in einem ersten Strompfad (I₁) ein Primärschalter (S1) der Schalteinrichtung angeordnet ist, und in einem parallel zu dem ersten Strompfad (I₁) angeordneten zweiten Strompfad (I₂) ein Sekundärschalter (S2) der Schalteinrichtung angeordnet ist, und in einem dritten Strompfad (I₃) parallel zum Sekundärschalter (S2) ein hochohmiger Schaltregler (SR) angeordnet ist, und in Reihe zum Sekundärschalter (S2) und zum Schaltregler (SR) ein niederohmiger Energiespeicher (C) angeordnet ist,und die Steuerung (SE) im ausgeschalteten Zustand (OFF) den Primärschalter (S1) und den Sekundärschalter (S2) dauerhaft ausschaltet, so dass der Schaltregler (SR) über den dritten Strompfad (I₃) die Eigenversorgungsspannung (U_{E}) zur Verfügung stellt, und im eingeschalteten Zustand (ON) den Primärschalter (S1) und den Sekundärschalter (S2) einschaltet, so dass der Energiespeicher (C) die Eigenversorgungsspannung (U_{E}) zur Verfügung stellt, und im eingeschalteten Zustand (ON) bei einem Unterschreiten einer minimalen Versorgungsspannung (U_{Emin}) den Primärschalter (S1) ausschaltet und bei einem Erreichen einer maximalen Versorgungsspannung (U_{Emax}) den Primärschalter (S1) einschaltet.

2. Elektronischer Schalter (1) nach Anspruch 1,
**dadurch gekennzeichnet, dass**
ein Spannungsregler (UR) zwischen der Eigenversorgungsspannung (U_{E}) und der Steuerung (SE) angeordnet ist und sowohl an dem Energiespeicher (C) und parallel dazu an dem Schaltregler (SR) angeschlossen ist.

3. Elektronischer Schalter (1) nach Anspruch 2,
**dadurch gekennzeichnet, dass**
der Spannungsregler (UR) die Eigenversorgungsspannung (U_{E}) zu einer relativ zur Eingangsspannung des Spannungsreglers (UR) niedrigeren Versorgungsspannung (U_{SE}) für die Steuerung (SE) herunterregelt.

4. Elektronischer Schalter (1) nach Anspruch 2,
**dadurch gekennzeichnet, dass**
der Spannungsregler (UR) die Eigenversorgungsspannung (U_{E}) zu einer relativ zur Eingangsspannung des Spannungsreglers (UR) höheren Versorgungsspannung (U_{SE}) für die Steuerung (SE) heraufregelt.

5. Elektronischer Schalter (1) nach einem der Ansprüche 1 bis 4,
**dadurch gekennzeichnet, dass**
in dem zweiten Strompfad (I₂) beziehungsweise dritten Strompfad (I₃) ein Gleichrichter (G) angeordnet ist.

6. Elektronischer Schalter (1) nach einem der Ansprüche 1 bis 5,
**dadurch gekennzeichnet, dass**
der Energiespeicher (C) ein niederohmiger Puffer-Kondensator ist.

7. Elektronischer Schalter (1) nach einem der Ansprüche 1 bis 6,
**dadurch gekennzeichnet, dass**
eine von der Steuerung (SE) unabhängige Begrenzungselektronik (BE) bei einem Überschreiten einer maximalen Versorgungsspannung (U_{Emax}) der Eigenversorgungsspannung (U_{E}) den Primärschalter (S1) zwangsweise unabhängig von der Steuerung (SE) einschaltet.

8. Elektronischer Schalter (1) nach einem der Ansprüche 1 bis 7,
**gekennzeichnet durch**
einen dritten elektrischen Anschluss (N) zum Anschließen eines N-Neutralleiters, der über eine erste Diode (D5) in Flussrichtung mit einem Eingang des Schaltreglers (SR) verbunden ist, und die Bezugsmasse (GND) des Energiespeichers (C) und des Schaltreglers (SR) über eine zweite Diode (D6) in Flussrichtung mit dem Anschluss (N) verbunden ist, und ein Tertiärschalter (S3) in Reihe zu der zweiten Diode (D6) zwischen dem Anschluss (N) und der Bezugsmasse (GND) des Energiespeichers (C) und des Schaltreglers (SR) angeordnet ist.

9. Elektronischer Schalter (1) nach Anspruch 8,
**dadurch gekennzeichnet, dass**
die Steuerung (SE) den Tertiärschalter (S3) im ausgeschalteten Zustand (OFF) leitend schaltet, um die Last (L) komplett stromfrei zu machen.

10. Elektronischer Schalter (1) nach einem der Ansprüche 1 bis 9,
**dadurch gekennzeichnet, dass**
die Steuerung (SE) einen Mikroprozessor aufweist, der über Ausgangssignale zumindest den Primärschalter (S1) und den Sekundärschalter (S2) der Schalteinrichtung steuert.

11. Elektronischer Schalter (1) nach einem der Ansprüche 1 bis 10,
**dadurch gekennzeichnet, dass**
durch ein erstes Detektionsmittel die Höhe und/oder Phasenlage des Laststroms (I_{L}) bestimmt werden kann.

12. Elektronischer Schalter (1) nach einem der Ansprüche 1 bis 11,
**dadurch gekennzeichnet, dass**
der Primärschalter (S1) zwei getrennte, in Reihe geschaltete Schalter (S1a, S1b) aufweist, die vorzugsweise beim Wechsel zwischen eingeschalteten Zustand und ausgeschalteten Zustand gemeinsam aus- und eingeschaltet werden.

13. Elektronischer Schalter (1) nach Anspruch 12,
**dadurch gekennzeichnet, dass**
zwischen den in Reihe geschalteten Schaltern (S1a, S1b) des Primärschalters (S1) ein Shunt-Widerstand (SH) als Teil des ersten Detektionsmittels zur Messung des durch den ersten Strompfad (I₁) fließenden Teil des Laststroms (I_{L}) durch die Steuerung (SE) in Reihe geschaltet ist und die über den Shunt-Widerstand (SH) abfallende Spannung (U_{SH}) als Eingangssignal zur Steuerung geleitet wird.

14. Elektronischer Schalter (1) nach einem der Ansprüche 1 bis 13,
**dadurch gekennzeichnet, dass**
durch ein zweites Detektionsmittel die aktuelle Eigenversorgungsspannung (U_{E}) als Eingangssignal an die Steuerung (SE) übertragen wird.

15. Elektronischer Schalter (1) nach einem der Ansprüche 1 bis 14,
**dadurch gekennzeichnet, dass**
durch ein drittes Detektionsmittel die Höhe und/oder Phasenlage der Wechselspannung (U_{N}) des Spannungsnetzes bestimmt wird.

16. Elektronischer Schalter (1) nach Anspruch 15,
**dadurch gekennzeichnet, dass**
das dritte Detektionsmittel zwischen dem ersten Anschluss (A) und dem zweiten Anschluss (B) geschaltet ist und zwei Dioden (D1, D3) und zwei strombegrenzende Widerstände (R3, R4) aufweist, über die die Wechselspannung (U_{N}) des Spannungsnetzes als Eingangssignal (O_{S4}) zur Steuerung (SE) geleitet wird.

17. Elektronischer Schalter (1) nach einem der Ansprüche 1 bis 16,
**dadurch gekennzeichnet, dass**
die Steuerung (SE) eine Dimmerfunktion mittels Phasen-Anschnitt-Funktion oder Phasen-Abschnitt-Funktion in Abhängigkeit der angeschlossenen Last (L) zur Verfügung stellt, wobei die Steuerung (SE) unterhalb eines Grenzwertes der Dimmstärke, insbesondere unterhalb 10 % der maximalen Dimmstärke, den Sekundärschalter (S2) einschaltet.

18. Elektronischer Schalter (1) nach einem der Ansprüche 1 bis 16,
**dadurch gekennzeichnet, dass**
die Steuerung (SE) den Primärschalter (S1) sowohl für die Schaltfunktion zwischen eingeschaltetem Zustand und ausgeschaltetem Zustand als auch für die Phasen-Anschnitt-Funktion oder Phasen-Abschnitt-Funktion einer Dimmerfunktion verwendet.

19. Elektronischer Schalter (1) nach einem der Ansprüche 1 bis 16,
**dadurch gekennzeichnet, dass**
der Primärschalter (S1) zwei getrennte, in Reihe geschaltete Schalter (S1a, S1b) aufweist, die beim Dimmen mit leichtem Zeitversatz, insbesondere mit max. 1 ms aus- und eingeschaltet werden.

## Claims

1. Electronic switch (1) for electrical installation technology, having a first electrical connection (A) for connecting an L-phase conductor of an AC voltage (U_{N}) of a voltage network, a second electrical connection (B) for connecting an electrical load (L), an electronic switching device at least for switching the load (L) between a switched-on state (ON) and a switched-off state (OFF), an electronic control unit (SE) for controlling the switching device, and means for an internal self-supply voltage (U_{E}) for the control unit (SE) using a load current (I_{L}) flowing through the load (L),
whereby
between the first connection (A) and the second connection (B) in a first current path (I₁) a primary switch (S1) of the switching device is arranged, and a secondary switch (S2) of the switching device is arranged in a secondary current path (I₂) parallel to the first current path (I₁) and in a third current path (I₃) parallel to the secondary switch (S2) a high-impedance switching regulator (SR) is arranged, and a low-impedance energy storage (C) is arranged in series with the secondary switch (S2) and the switching regulator (SR), and the control unit (SE) permanently switches off the primary switch (S1) and the secondary switch (S2) in the switched-off state (OFF), so that the switching regulator (SR) provides via the third current path (I₃) the self-supply voltage (U_{E}), and in the switched-on state (ON) switches on the primary switch (S1) and the secondary switch (S2) so that the energy storage (C) provides the self-supply voltage (U_{E}), and in the switched-on state (ON) when the supply voltage falls below a minimum supply voltage (U_{Emin}) switches off the primary switch (S1) and when a maximum supply voltage (U_{Emax}) is reached switches on the primary switch (S1).

2. Electronic switch (1) according to claim 1,
**characterized in that**
a voltage regulator (UR) is arranged between the self-supply voltage (U_{E}) and the control unit (SE) and is connected both to the energy storage (C) and simultaneously to the switching regulator (SR).

3. Electronic switch (1) according to claim 2,
**characterized in that**
the voltage regulator (UR) regulates the self-supply voltage (U_{E}) for the control unit (SE) down to a lower supply voltage (U_{SE}) compared to the input voltage of the voltage regulator (UR).

4. Electronic switch (1) according to claim 2,
**characterized in that**
the voltage regulator (UR) regulates the self-supply voltage (U_{E}) for the control unit (SE) to a higher supply voltage (U_{SE}) compared to the input voltage of the voltage regulator (UR).

5. Electronic switch (1) according to any one of claims 1 to 4,
**characterized in that**
a rectifier (G) is arranged in the second current path (I₂) or third current path (I₃).

6. Electronic switch (1) according to any one of claims 1 to 5,
**characterized in that**
the energy storage (C) is a low-impedance buffer capacitor.

7. Electronic switch (1) according to any one of claims 1 to 6,
**characterized in that**
a limiting electronic (BE), which is independent of the control unit (SE), forcibly switches on the primary switch (S1) independently of the control unit (SE) if a maximum supply voltage (U_{Emax}) of the self-supply voltage (U_{E}) is exceeded.

8. Electronic switch (1) according to any one of claims 1 to 7,
**characterized by**
a third electrical connection (N) for connecting an N-neutral conductor, which is connected to an input of the switching regulator (SR) via a first diode (D5) in the direction of flow, and the reference ground (GND) of the energy storage (C) and the switching regulator (SR) via a second diode (D6) in the direction of the flow is connected to the connection (N), and a tertiary switch (S3) in series with the second diode (D6) is arranged between the connection (N) and the reference ground (GND) of the energy storage (C) and the switching regulator (SR).

9. Electronic switch (1) according to claim 8,
**characterized in that**
the control unit (SE) conductively switches the tertiary switch (S3) in the switched-off state (OFF) to make the load (L) completely current-free.

10. Electronic switch (1) according to any one of claims 1 to 9,
**characterized in that**
the control unit (SE) has a microprocessor which controls at least the primary switch (S1) and the secondary switch (S2) of the switching device via output signals.

11. Electronic switch (1) according to any one of claims 1 to 10,
**characterized in that**
the level and/or phase position of the load current (I_{L}) can be determined by a first detection means.

12. Electronic switch (1) according to any one of claims 1 to 11,
**characterized in that**
the primary switch (S1) has two separate switches (S1a, S1b) connected in series, which are preferably switched off and on together when changing between the switched-on state and the switched-off state.

13. Electronic switch (1) according to claim 12,
**characterized in that**
a shunt resistor (SH) is connected in series between the series-connected switches (S1a, S1b) of the primary switch (S1) as part of the first detection means for measuring the part of the load current (I_{L}) flowing through the first current path (I₁) through the control unit (SE) and the voltage (U_{SH}) dropping across the shunt resistor (SH) is fed to the control unit as an input signal.

14. Electronic switch (1) according to any one of claims 1 to 13,
**characterized in that**
the current self-supply voltage (U_{E}) is transmitted to the control unit (SE) as an input signal by a second detection means.

15. Electronic switch (1) according to any one of claims 1 to 14,
**characterized in that**
the level and/or phase position of the AC voltage (U_{N}) is determined by a third detection means.of the voltage network .

16. Electronic switch (1) according to claim 15,
**characterized in that**
the third detection means is connected between the first connection (A) and the second connection (B) and has two diodes (D1, D3) and two current-limiting resistors (R3, R4) via which the AC voltage (U_{N}) of the voltage network is fed as an input signal (O_{S4}) to the control unit (SE) .

17. Electronic switch (1) according to any one of claims 1 to 16,
**characterized in that**
the control unit (SE) provides a dimmer function by means of a phase cut-on function or phase cut-off function depending on the connected load (L), whereby the control unit (SE) switches on the secondary switch (S2) below a limit value of the dimming intensity, in particular below 10 % of the maximum dimming intensity.

18. Electronic switch (1) according to any one of claims 1 to 16,
**characterized in that**
the control unit (SE) uses the primary switch (S1) both for the switching function between the switched-on state and the switched-off state and for the phase cut-on function or phase cut-off function of a dimmer function.

19. Electronic switch (1) according to any one of claims 1 to 16,
**characterized in that**
the primary switch (S1) has two separate switches (S1a, S1b) connected in series, which are switched off and on with a slight time offset, in particular with a maximum of 1 ms, during dimming.

## Revendications

1. Commutateur électronique (1) pour installations électriques, comportant une première borne électrique (A) pour raccorder un conducteur de phase L d'une tension alternative (U_{N}) d'un réseau électrique, une deuxième borne électrique (B) pour raccorder une charge électrique (L), un dispositif de commutation électronique pour au moins commuter la charge (L) entre un état activé (ON) et un état désactivé (OFF), une unité de commande électronique (SE) pour commander le dispositif de commutation, et des moyens pour une tension d'auto-alimentation interne (U_{E}) pour la commande (SE) en utilisant un courant de charge (I_{L}) circulant à travers la charge (L),
selon lequel un commutateur primaire (S1) du dispositif de commutation est disposé entre la première borne (A) et la deuxième borne (B) sur un premier chemin courant (I₁), et un commutateur secondaire (S2) du dispositif de commutation est disposé sur un deuxième chemin courant (I₂) parallèle au premier chemin courant (I₁), et un régulateur de commutation à haute impédance (SR) est disposé sur un troisième chemin courant (I₃) parallèle au commutateur secondaire (S2), et un accumulateur d'énergie à faible impédance (C) est disposé en série avec le commutateur secondaire (S2) et le régulateur de commutation (SR), et l'unité de commande (SE) à l'état désactivé (OFF) désactive de manière permanente le commutateur primaire (S1) et le commutateur secondaire (S2), de telle sorte que le régulateur de commutation (SR) fournisse la tension d'auto-alimentation interne (U_{E}) par l'intermédiaire du troisième chemin courant (I₃) et, à l'état activé (ON), active le commutateur primaire (S1) et le commutateur secondaire (S2) de telle sorte que l'accumulateur d'énergie (C) fournisse la tension d'auto-alimentation (U_{E}) et, à l'état activé (ON), lorsque la tension d'alimentation s'abaisse en dessous d'une tension minimale (U_{Emin}), désactive le commutateur primaire (S1) et, lorsqu'une tension d'alimentation maximale (U_{Emax}) est atteinte, active le commutateur primaire (S1).

2. Commutateur électronique (1) selon la revendication 1,
**caractérisé en ce que**
un régulateur de tension (UR) est disposé entre la tension d'auto-alimention (U_{E}) et l'unité de commande (SE) et est connecté à l'accumulateur d'énergie (C) et, parallélement, au régulateur de commutation (SR).

3. Commutateur électronique (1) selon la revendication 2,
**caractérisé en ce que**
le régulateur de tension (UR) réduit la tension d'auto-alimentation (U_{E}) à une tension d'alimentation (U_{SE}) plus faible par rapport à la tension d'entrée du régulateur de tension (UR) pour la commande (SE).

4. Commutateur électronique (1) selon la revendication 2,
**caractérisé en ce que**
le régulateur de tension (UR) augmente la tension d'auto-alimentation (U_{E}) à une tension d'alimentation (U_{SE}), qui est supérieure par rapport à la tension d'entrée du régulateur de tension (UR) pour la commande (SE).

5. Commutateur électronique (1) selon l'une quelconque des revendications 1 à 4,
**caractérisé en ce que**
un redresseur (G) est disposé sur le deuxième chemin courant (I₃) ou le troisième chemin courant (I₃).

6. Commutateur électronique (1) selon l'une quelconque des revendications 1 à 5,
**caractérisé en ce que**
l'accumulateur d'énergie (C) est un condensateur tampon à faible impédance.

7. Commutateur électronique (1) selon l'une quelconque des revendications 1 à 6,
**caractérisé en ce que**
une unité électronique de limitation (BE) indépendante de l'unité de commande (SE) active le commutateur primaire (S1) de force, indépendamment de l'unité de commande (SE), dans le cas où la tension d'auto-alimentation (U_{E}) dépasse une tension d'alimentation maximale (U_{Emax}).

8. Commutateur électronique (1) selon l'une quelconque des revendications 1 à 7,
**caractérisé par**
une troisième borne électrique (N) pour raccorder un conducteur neutre **N,** qui est connecté par l'intermédiaire d'une première diode (D5) dans le sens du flux à une entrée du régulateur de commutation (SR), et la masse de référence (GND) de l'accumulateur d'énergie (C) et du régulateur de commutation (SR) est connectée à la borne (N) par l'intermédiaire d'une deuxième diode (D6) dans le sens du flux, et un commutateur tertiaire (S3) est disposé en série avec la deuxième diode (D6) entre la borne (N) et la masse de référence (GND) de l'accumulateur d'énergie (C) et du régulateur de commutation (SR).

9. Commutateur électronique (1) selon la revendication 8,
**caractérisé en ce que**
l'unité de commande (SE) commute en conduction le commutateur tertiaire (S3) à l'état désactivé (OFF) afin de mettre la charge (L) complètement hors tension.

10. Commutateur électronique (1) selon l'une quelconque des revendications 1 à 9,
**caractérisé en ce que**
l'unité de commande (SE) comporte un microprocesseur qui commande, par l'intermédiaire de signaux de sortie, au moins le commutateur primaire (S1) et le commutateur secondaire (S2) du dispositif de commutation.

11. Commutateur électronique (1) selon l'une quelconque des revendications 1 à 10,
**caractérisé en ce que**
le niveau et/ou la position de phase du courant de charge (I_{L}) peuvent être déterminées par un premier moyen de détection.

12. Commutateur électronique (1) selon l'une quelconque des revendications 1 à 11,
**caractérisé en ce que**
le commutateur primaire (S1) comporte deux commutateurs séparés (S1a, S1b) montés en série, qui sont ouverts et fermés ensemble, de préférence lors du passage à l'état désactivé et à l'état activé.

13. Commutateur électronique (1) selon la revendication 12,
**caractérisé en ce que**
une résistance shunt (SH) est connectée en série entre les commutateurs (S1a, S1b) connectés en série du commutateur primaire (S1) en tant que partie du premier moyen de détection pour mesurer la partie du courant de charge (I_{L}) circulant à travers le premier chemin de courant (I₁) à travers la commande (SE) et la tension (U_{SH}) chutant est transmise à la commande via la résistance shunt (SH) comme signal d'entrée.

14. Commutateur électronique (1) selon l'une quelconque des revendications 1 à 13,
**caractérisé en ce que**
la tension d'auto-alimentation (U_{E}) actuelle est transmise à l'unité de commande (SE) par un deuxième moyen de détection en tant que signal d'entrée.

15. Commutateur électronique (1) selon l'une quelconque des revendications 1 à 14,
**caractérisé en ce que**
le niveau et/ou la position de phase de la tension alternative (U_{N}) du réseau électrique sont déterminées par un troisième moyen de détection.

16. Commutateur électronique (1) selon la revendication 15,
**caractérisé en ce que**
le troisième moyen de détection est connecté entre la première borne (A) et la deuxième borne (B) et comporte deux diodes (D1, D3) et deux résistances limitant le courant (R3, R4) par l'intermédiaire desquelles la tension alternative (U_{N}) du réseau électrique est guidée en tant que signal d'entrée (O_{S4}) vers l'unité de commande (SE).

17. Commutateur électronique (1) selon l'une quelconque des revendications 1 à 16,
**caractérisé en ce que**
l'unité de commande (SE) fournit une fonction de gradation au moyen d'une fonction de découpage de phase directe ou d'une fonction de découpage de phase inversée en fonction de la charge connectée (L), l'unité de commande (SE) activant le commutateur secondaire (S2) en dessous d'une valeur limite de l'intensité de gradation, notamment en dessous de 10 % de l'intensité de gradation maximale.

18. Commutateur électronique (1) selon l'une quelconque des revendications 1 à 16,
**caractérisé en ce que**
l'unité de commande (SE) utilise le commutateur primaire (S1) à la fois pour la fonction de commutation entre l'état activé et l'état désactivé et pour la fonction de découpage de phase directe ou la fonction de découpage de phase inversée d'une fonction de gradation.

19. Commutateur électronique (1) selon l'une quelconque des revendications 1 à 16,
**caractérisé en ce que**
le commutateur primaire (S1) comporte deux commutateurs séparés (S1a, S1b) montés en série, qui sont désactivés et activés avec un léger décalage temporel, notamment avec un maximum de 1 ms, lors de la gradation.
